# EUROPEAN PATENT APPLICATION

(11) **EP 3 321 794 A1**
(43) Date of publication of application: **16.05.2018**
(21) Application number: 15906761.0
(22) Date of filing: 23.10.2015
(51) Int. Cl.: G06F 3/16, G10L 25/78

(54) **ELECTRONIC DEVICE AND CONTROL METHOD THEREFOR**

(71) Applicant: Samsung Electronics Co., Ltd., Suwon-si, Gyeonggi-do 16677 (KR)
(72) Inventor: JO, Seok-hwan, Suwon-si Gyeonggi-do 16700 (KR); KIM, Do-hyung, Hwaseong-si Gyeonggi-do 18443 (KR); KIM, Jae-hyun, Seoul 06578 (KR)
(74) Representative: HGF Limited
(86) International application number: PCT/KR2015/011263
(87) International publication number: WO 2017/069310

(57) **Abstract**

An electronic device and a control method therefor are provided. The electronic device comprises: a microphone for receiving an external audio signal; an analog/digital converter (ADC) for processing the audio signal into a digital signal; a memory for storing the audio signal; and a processor for identifying whether the audio signal inputted from the microphone is a user's voice, and compressing the audio signal on the basis of the determination result so as to store the compressed audio signal in the memory, wherein the ADC and the processor can be implemented as one chip.

## Description

### [TECHNICAL FIELD]

The present disclosure relates to an electronic device and a controlling method thereof, and more particularly to an electronic device that activates an electronic device through a user voice and executes a function of an application, and a controlling method thereof

### [DESCRIPTION OF RELATED ART]

In recent years, the technology for controlling an electronic device by using a user voice input through a microphone has been adopted for various electronic devices. For example, a smart TV may change a channel and control volume through a user voice, and a smart phone may obtain various information through a user voice.

Especially, an electronic device may be activated by using a user voice while the electronic device is inactivated. Here, the user voice for activating the electronic device is called a trigger voice. In order for the electronic device to recognize the trigger voice, a component for recognizing the trigger voice has to be activated while the electronic device is inactivated. Especially, if the component for recognizing the trigger voice is turned on while the electronic device is inactivated, the problem that the power for the component for recognizing the trigger voice is consumed may occur. That is, it is required to drive the component for recognizing the trigger voice with low power.

In addition, if a follow-up instruction is received sequentially in addition to the trigger voice, the capacity of a memory may should become bigger in order to store the audio signal corresponding to the trigger voice and a follow-up instruction. If the capacity of the memory grows, the problem may occur that the power consumption for the component for recognizing the trigger voice grows.

Accordingly, it is required to find a method for driving the component for recognizing the trigger voice with low power and a method for minimizing the size of a buffer for storing the trigger voice and the follow-up instruction.

### [DETAILED DESCRIPTION]

### [PROBLEM TO BE SOLVED]

The present disclosure has been made to solve the above problem and to provide an electronic device that may drive a component for recognizing a trigger voice with low power and minimize a size of a memory which stores an audio signal, and a controlling method thereof

### [MEANS OF SOLVING THE PROBLEMS]

According to an embodiment, there is provided an electronic device including a microphone configured to receive an external audio signal, an Analog/Digital Converter (ADC) configured to process the audio signal to a digital signal, a memory configured to store the audio signal, and a processor configured to identify whether an audio signal input from the microphone is a user voice, compress the audio signal based on the determination result, and store the compressed audio signal in the memory, and the ADC and the processor may be implemented as a single chip.

The processor, in response to identifying that an audio signal input from the microphone is a user voice, may compress the audio signal and stores the compressed audio signal in the memory, and in response to identifying that an audio signal input from the microphone is not a user voice, may not compress the audio signal.

The processor may identify whether the compressed audio signal is recovered by identifying whether part of the audio signal is a trigger voice for activating the electronic device.

The electronic device includes an application processor configured to control an application driven in the electronic device, and the processor, in response to identifying that part of the audio signal is the trigger voice, may recover the compressed audio signal and outputs the recovered audio signal to the application processor, and in response to identifying that the audio signal is not the trigger voice, may not recover the compressed audio signal stored in the memory.

The processor, in response to identifying that part of the audio signal is the trigger voice, may output a signal for activating the application processor to the application processor.

The application processor, in response to the recovered audio signal being input, may activate an application corresponding to the audio signal and performs a function of an application by using an instruction excluding part of the audio signal corresponding to the trigger voice.

The processor may identify a probability of part of the audio signal corresponding to the trigger voice in real time while the audio signal is compressed, and in response to identifying that the probability identified in real time is less than a predetermined value, stop compression of the audio signal, and in response to a final probability that part of the audio signal corresponds to the trigger voice being equal to or greater than a predetermined value, compress a section corresponding to a remaining instruction excluding part of the audio signal and store the compressed section in the memory.

According to an embodiment, there is provided a method for controlling an electronic device including receiving an external audio signal, identifying whether an audio signal input from the microphone is a user voice, and compressing the input audio signal based on the determination result and storing the compressed audio signal in a memory.

The storing may comprise, in response to identifying that an audio signal input from the microphone is a user voice, compressing the audio signal and storing the compressed audio signal in the memory, and in response to identifying that an audio signal input from the microphone is not a user voice, not compressing the audio signal.

The method may further include identifying whether part of the audio signal is a trigger voice for activating the electronic device, and identifying whether the compressed audio signal is recovered.

The method may include, in response to identifying that the audio signal is not the trigger voice, not recovering the compressed audio signal stored in the memory, and in response to identifying that part of the audio signal is the trigger voice, recovering the compressed audio signal and outputting the recovered audio signal to the application processor.

The method may include, in response to identifying that part of the audio signal is the trigger voice, outputting a signal for activating the application processor to the application processor.

The method may include, in response to the recovered audio signal being input, activating an application corresponding to the audio signal by the application processor, and performing a function of an application by using an instruction excluding part of the audio signal corresponding to the trigger voice.

The identifying may include identifying a probability of part of the audio signal corresponding to the trigger voice in real time while the audio signal is compressed, and stopping compression of the audio signal in response to identifying that the change identified in real time is less than a predetermined value, and the method may include, in response to a final probability that part of the audio signal corresponds to the trigger voice being equal to or greater than a predetermined value, compressing a section corresponding to a remaining instruction excluding part of the audio signal and storing the compressed section in the memory.

According to an embodiment, there is provided a computer readable recording medium which includes a program that executes a method for controlling an electronic device, wherein the controlling method includes receiving an external audio signal, identifying whether an audio signal input from the microphone is a user voice, and compressing the input audio signal based on the determination result and storing the compressed audio signal in a memory.

### [EFFECTS OF THE INVENTION]

According to various embodiments, a chip for recognizing a trigger voice may be driven with low power, and a function corresponding to a follow-up instruction may be executed rapidly by recognizing the follow-up instruction in addition to the trigger voice.

### [BRIEF DESCRIPTION OF THE DRAWINGS]

FIG. 1 is a view illustrating a brief configuration of an electronic device according to an embodiment;
FIG. 2 is a view illustrating a detailed configuration of an electronic device according to an embodiment;
FIG. 3 is a block diagram illustrating a plurality of configurations for an electronic device to compress a trigger voice according to an embodiment;
FIGS. 4A and 4B are block diagrams illustrating configurations of an encoder and a decoder according to various embodiments;
FIG. 5 is a graph illustrating a method for identifying a trigger voice using a trigger voice probability according to an embodiment;
FIGS. 6A to 6C are views illustrating a method for implementing a processor for compressing a trigger voice according to various embodiments; and
FIGS. 7 and 8 are flow charts illustrating a controlling method of an electronic device according to various embodiments.

### [DETAILED DESCRIPTION]

The above and other aspects, features, and advantages of certain embodiments of the present disclosure will be more apparent from the following description taken in conjunction with the accompanying drawings. However, it should be understood that the present disclosure is not limited to the specific embodiments described hereinafter, but includes various modifications, equivalents, and/or alternatives of the embodiments of the present disclosure. In relation to explanation of the drawings, similar drawing reference numerals may be used for similar constituent elements.

In the description, the term "has", "may have", "includes" or "may include" indicates existence of a corresponding feature (e.g., a numerical value, a function, an operation, or a constituent element such as a component), but does not exclude existence of an additional feature.

In the description, the term "A or B", "at least one of A or/and B", or "one or more of A or/and B" may include all possible combinations of the items that are enumerated together. For example, the term "A or B" or "at least one of A or/and B" may designate (1) at least one A, (2) at least one B, or (3) both at least one A and at least one B.

The expression "1", "2", "first", or "second" as used herein may modify a variety of elements, irrespective of order and/or importance thereof, and only to distinguish one element from another. Accordingly, without limiting the corresponding elements. For example, a first user appliance and a second user appliance may indicate different user appliances regardless of their order or importance. For example, without departing from the scope as described herein, a first element may be referred to as a second element, or similarly, a second element may be referred to as a first element.

If it is described that a certain element (e.g., first element) is "(operatively or communicatively) coupled with/to" or is "connected to" another element (e.g., second element), it should be understood that the certain element may be connected to the other element directly or through still another element (e.g., third element). Meanwhile, when it is mentioned that one element (e.g., first element) is "directly coupled" with or "directly connected to" another element (e.g., second element), it may be understood that there is no element (e.g., third element) present between one element and another element.

In the description, the term "configured to" may be changed to, for example, "suitable for", "having the capacity to", "designed to", "adapted to", "made to", or "capable of" under certain circumstances. The term "configured to (set to)" does not necessarily mean "specifically designed to" in a hardware level. Under certain circumstances, the term "device configured to" may refer to "device capable of" doing something together with another device or components. For example, the phrase "processor configured to perform A, B, and C" may denote or refer to a dedicated processor (e.g., embedded processor) for performing the corresponding operations or a generic-purpose processor (e.g., CPU or application processor) that can perform the corresponding operations through execution of one or more software programs stored in a memory device.

The terms used in the description are used to merely describe a specific embodiment, but may not intend to limit the scope of other embodiments. Unless otherwise defined specifically, a singular expression may encompass a plural expression. All terms (including technical and scientific terms) used in the description could be used as meanings commonly understood by those ordinary skilled in the art to which the present disclosure belongs. The terms that are used in the present disclosure and are defined in a general dictionary may be used as meanings that are identical or similar to the meanings of the terms from the context of the related art, and they are not interpreted ideally or excessively unless they have been clearly and specially defined. According to circumstances, even the terms defined in the embodiments of the present disclosure should not be interpreted as excluding the embodiments of the present disclosure.

An electronic device according to various embodiments of the present disclosure may include, for example, at least one of a smart phone, a tablet PC (Personal Computer), a mobile phone, a video phone, an e-book reader, a desktop PC (Personal Computer), a laptop PC (Personal Computer), a net book computer, a workstation, a server, a PDA (Personal Digital Assistant), a PMP (Portable Multimedia Player), an MP3 player, a mobile medical device, a camera, and a wearable device. According to various embodiments, the wearable device may include at least one of an accessory type (e.g.: watch, ring, bracelet, ankle bracelet, necklace, glasses, contact lens, or head-mounted-device (HMD)), fabric or cloth-embedded type (e.g.: e-cloth), body-attached type (e.g.: skin pad or tattoo), or bioimplant circuit (e.g.: implantable circuit).

In another embodiment, an electronic device may be a home appliance. The electronic device may include, for example, at least one of television, digital video disk (DVD) player, audio, refrigerator, air-conditioner, cleaner, oven, microwave, washing machine, air cleaner, set top box, home automation control panel, security control panel, TV box (ex: Samsung HomeSyncM, Apple TVTM, or Google TVTM), game console (ex: XboxTM, PlayStationTM), e-dictionary, e-key, camcorder, or e-frame.

In another embodiment, an electronic device may include various medical devices (ex: various portable medical measuring devices (blood glucose monitor, heart rate monitor, blood pressure measuring device, or body temperature measuring device, etc.), magnetic resonance angiography (MRA), magnetic resonance imaging (MRI), computed tomography (CT), photographing device, or ultrasonic device, etc.), navigator, global navigation satellite system (GNSS), event data recorder (EDR), flight data recorder (FDR), vehicle info-tainment device, e-device for ships (ex: navigation device for ship, gyrocompass, etc.), avionics, security device, head unit for vehicles, industrial or home-use robots, drone, ATM of financial institutions, point of sales (POS) of shops, or internet of things device (ex: bulb, sensors, sprinkler, fire alarm, temperature controller, streetlight, toaster, sporting goods, hot water tank, heater, boiler, etc.).

According to some embodiments, an electronic device may include at least one of furniture, a part of a building/construction or vehicle, electronic board, electronic signature receiving device, projector, or various measuring devices (ex: water, electricity, gas, or wave measuring device, etc.). In various embodiments, the electronic device may be a combination of one or more of the above-described devices. In a certain embodiment, the electronic device may be a flexible electronic device. Further, the electronic device according to the embodiments of the present disclosure is not limited to the above-described devices, but may include new electronic devices in accordance with the technical development.

Hereinafter an electronic device according to various electronic devices will be described with reference to the accompanying drawings. In this disclosure, the term "a user" may indicate a person using an electronic device, a person who is sensed by a device or who causes an event for a device. The number of use may be a plural.

In an embodiment, the term "user voice" may refer to a voice of a certain person who uses an electronic device, but it is merely an embodiment, the "user voice" may be a voice of any person.

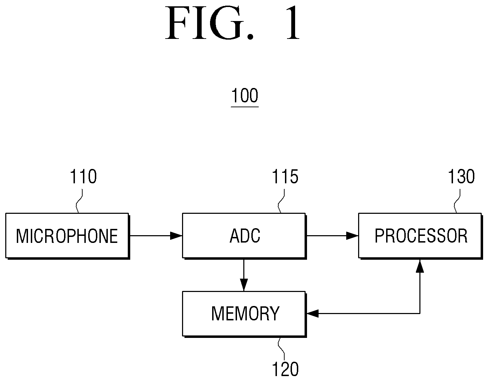

FIG. 1 is a block diagram illustrating a brief configuration of an electronic device 100 according to an embodiment. As illustrated in FIG. 1, the electronic device 100 includes a microphone 110, an ADC 115, a memory 120, and a processor 130. Meanwhile, according to an embodiment, the ADC 115, the memory 120 and the processor 130 may be implemented in a single chip.

The microphone 110 receives an audio signal from outside. Here, the audio signal may include a user voice, and the user voice may include a trigger voice for activating the electronic device 100 and an instruction for controlling the electronic device 100.

The ADC 115 processes an audio signal received through a microphone to an audio signal in a digital form.

The memory 120 stores an audio signal processed by the ADC 115. Especially, the memory 120 may store a compressed audio signal. Here, the memory 120 may be implemented as a buffer of which a size is smaller than a predetermined size.

The processor 130 identifies whether the audio signal input from the microphone 110 is a user voice, compresses the audio signal input based on the determination result, and stores the compressed audio signal in the memory 120.

Specifically, if it is identified that the audio signal input from the microphone 110 is a user voice, the processor 130 may compress the audio signal and store the compressed audio signal in the memory 120. However, if it is identified that the audio signal input from the microphone 110 is not the user voice, the processor 130 may not compress and delete the audio signal.

In addition, the processor 120 may identify whether part of the input audio signal is the trigger voice for activating the electronic device 100, and identify whether the compressed audio signal is recovered.

Specifically, if it is identified that part of the audio signal is a trigger voice, the processor 130 may recover the compressed audio signal and output the recovered audio signal to an application processor (hereinafter referred to as "AP"). Especially, if it is identified that part of the audio signal is a trigger voice, the processor 130 may output the signal for activating the AP to the AP. Here, if the AP receives the recovered audio signal, the AP may activate the application corresponding to the audio signal and perform the function of the application using the instruction excluding part of the audio signal corresponding to the trigger voice.

Especially, the processor 130 may identify the probability that the part of the audio signal corresponds to the trigger voice, while the audio signal is compressed. In addition, if the probability identified in real time is greater than a predetermined value, the processor 130 may continuously perform compression of the audio signal. However, if the probability identified in real time is less than the predetermined value, the processor 130 may stop the compression of the audio signal.

In addition, finally, if it is identified that the trigger signal is not included in the audio signal, the processor 130 may not recover the compressed audio signal stored in the memory 120.

However, if the probability identified in real time is less than a predetermined value and thus the compression of the audio signal is stopped, and if a final probability that part of the audio signal corresponds to the trigger voice is greater than a predetermined value, the processor 130 may compress the section corresponding to a remaining instruction excluding the part of the audio signal and store the compressed section in the memory 120. In addition, the processor 130 may recover the section corresponding to the instruction stored in the memory 120 and output the recovered section to the AP.

According to the above described various embodiments, the electronic device 100 may drive the chip for recognizing the trigger voice with low power, and rapidly execute the function corresponding to the follow-up instruction by rapidly recognizing the follow-up instruction in addition to the trigger voice.

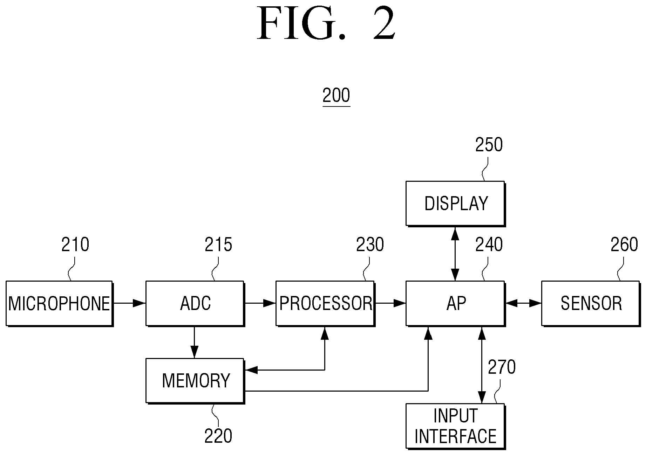

FIG. 2 is a block diagram illustrating a detailed configuration of the electronic device 200 according to an embodiment. As illustrated in FIG. 2, the electronic device includes the microphone 210, the ADC 215, the memory 220, the processor 230, the AP 240, the display 250, the sensor 260, and an input interface 270.

The microphone 210 receives an audio signal. Here, the audio signal may include a user voice, and the user voice may include a trigger voice and an instruction. Here, the trigger voice may be a voice for activating the electronic device 100 which is in an inactivation status. The instruction may be a voice for executing a specific function in a specific application of the electronic device 100. For example, the user voice may include a trigger voice such as "Hi, Galaxy." and an instruction such as "What time is it?". In addition, the trigger voice and the instruction may be input sequentially. That is, the instruction may be input right after the trigger voice is input.

The microphone 210 may be included in a main body of the electronic device 200, but it is merely an embodiment, and the microphone 210 may be provided at an exterior of the electronic device 200 and connected with the electronic device 200 in a wired/wireless manner.

The ADC 215 processes the audio signal received through the microphone as an audio signal in a digital form. Here, the ADC 215 may be implemented in a single chip together with the memory 210 and the processor 230.

The memory 220 receives an audio signal input through the microphone 210. Especially, the memory 220 may include a first buffer which temporarily stores an audio signal input through the microphone 210 and a second buffer which stores a compressed audio signal.

In an existing method, in order to store an audio signal of five seconds long, 16kHz x 16 bit x 5sec x 2ch= 312.5kbyte of buffer is required.

However, according to an embodiment, the first buffer only requires audio data of 10ms long in length to identify whether an audio signal is a user voice. Accordingly, the first buffer may have the size of 16kHz x 16 bit x 10 msec x 2ch x 2 =1.25kbyte. In addition, the second buffer may have the size of 12.65kbps x 5 sec x 2ch =18kbyte (based on G.722.2 12.65kbps) in order to store a compressed audio signal of five seconds long.

That is, according to an embodiment, the sizes of the first buffer and the second buffer are much lesser than the size of an existing buffer. Accordingly, the electronic device 100 may drive the chip for recognizing a trigger voice with low power because the size of the audio buffer of the electronic device is reduced.

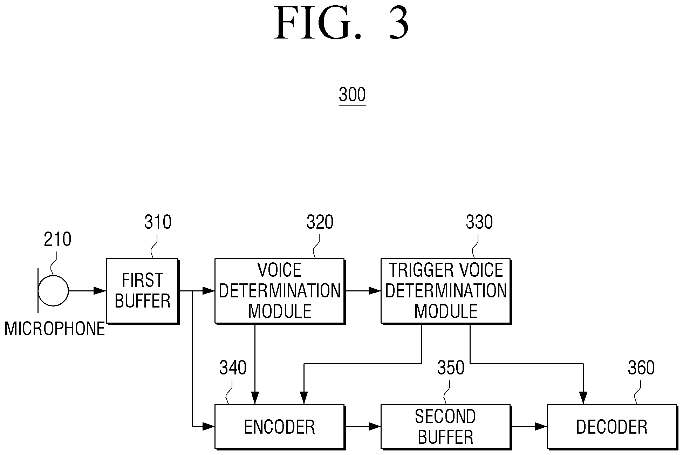

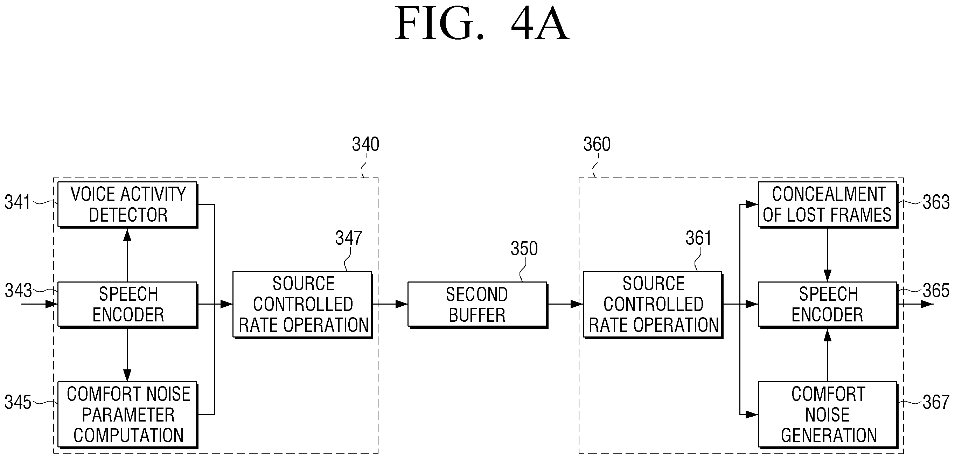

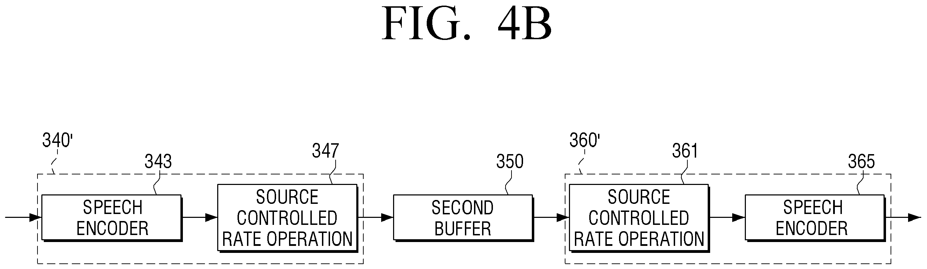

In addition, as illustrated in FIG. 3, the memory 220 may include various modules such as a voice determination module 320, a trigger voice determination module 330, an encoder 340 and a decoder 360. Especially, the encoder 340 and the decoder 360 may be implemented as G.722.2 technology (Adaptive Multi-Rate Wideband, AMR-WB) which is an example of a vocoder, as illustrated in FIG. 4A. That is, the encoder 340 may include a Voice Activity Detection module 341, Speech Encoder module 343, Comfort Noise Parameter Computation module 345, and Soure Controlled Rate Operation module 347, and the decoder 360 may include a Soure Controlled Rate Operation module 361, Concealment of lost frame module 363, Speech Decoder module 365, and Comfort Noise Generation module 367. Meanwhile, in an embodiment, the trigger voice, not a general voice, is compressed and recovered, and in order to reduce a consumption of a dynamic power and perform compression and recovery more rapidly, as illustrated in FIG. 4B, the Comfort Noise Parameter Computation module 345, the Concealment of lost frame module 363, and the Comfort Noise Generation module 367 may be removed. In addition, since the function of the Voice Activity Detection module 341 is the same as the function of a voice sensor 320, the Voice Activity Detection module 341 may be removed and the corresponding function may be performed through a module of the voice sensor 320.

The AP 240 controls overall operations of the electronic device 200. Especially, the AP 240 may provide various functions of the electronic device 200 to a user by driving at least one application. Meanwhile, in an embodiment, it has been defined as AP, but it is only an embodiment, and various processors which may control the electronic device 200 may be implemented when the electronic device 200 is in an activation status.

The display 250 outputs image data. Especially, the display 250 may display various application execution screens by a control of the AP 240. Especially, the display 250 may be implemented flexibly, transparently, and in a wearable manner. A panel included in the display 250 may be implemented in a single module with a touch panel.

The sensor 260 may measure a physical quantity or sense an operation statue of an electronic device 201, and convert the measured or sensed information into an electric signal. The sensor 260 may include, for example, a gesture sensor, a gyro sensor, an atmospheric pressure sensor, a magnetic sensor, an acceleration sensor, a grip sensor, a proximity sensor, a color sensor, a biosensor, a temperature-humidity sensor, an illuminance sensor, an ultra violet (UV) sensor, an E-nose sensor, an electromyography (EMG) sensor, an electroencephalogram (EEG) sensor, an electrocardiogram (ECG) sensor, an infrared (IR) sensor, an iris sensor and/or a fingerprint sensor. The sensor 260 may further include a control circuit for controlling at least one or more sensors therein. According to an embodiment, the electronic device 200 may further include a processor configured to control the sensor 260 as part of the processor 230 and the AP 240 or additionally, and control the sensor 260 while the processor 230 or the AP 240 are in a sleeping state.

The input interface 270 may receive various user instructions. Here, the input interface 270 may be implemented as various input devices such as a touch panel, a button, a remote controller, a key board, a mouse, and a pointer.

The processor 230 may identify whether the electronic device 200 is activated by using an audio signal input through a microphone 210 while the electronic device 200 is inactivated, and transmit the instruction included in the received audio signal to the AP 240.

Especially, as illustrated in FIG. 3, the processor 230 may identify whether the electronic device 200 is activated by using various modules and buffers stored in the memory 220, and transmit the instruction included in the received audio signal to the AP 240.

In detail, while the electronic device 200 maintains an inactivated status, the microphone 210 may receive an audio signal. Here, the inactivation of the electronic device 200 refers to the state that the configuration other than the configuration which identifies whether a trigger voice is input to the electronic device 200 (e.g., the microphone 210, the memory 220, and the processor 230, etc.) is turned off, or does not perform a function thereof.

In addition, the first buffer 310 may store the audio signal input through the microphone 210 temporarily. Here, the first buffer 310 may store the audio signal section of 10ms long with which whether the input audio signal is a user voice may be identified.

In addition, a voice determination module 320 may identify whether the input audio signal includes a user voice. Specifically, the voice determination module 320 may analyze the frequency of the input audio signal and identify whether the input audio signal is a user voice.

If it is identified that the input audio signal includes a user voice, the voice determination module 320 may control an encoder 340 to compress the input audio signal by turning on the encoder 340.

The encoder 340 may compress the input audio signal and store the compressed audio signal in the second buffer 350.

In addition, a trigger voice determination module 330 may identify whether the input audio signal includes a trigger voice. Specifically, while the encoder 340 compresses the audio signal, the trigger voice determination module 330 may identify a similarity probability between the input audio signal and a pre-stored trigger voice signal in real time. In addition, the trigger voice determination module 330 may stop the compression operation of an encoder 340 based on the similarity probability.

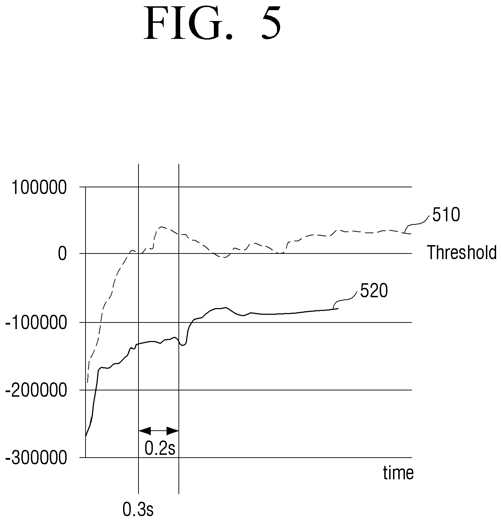

For example, as reference numeral 520 illustrated in FIG. 5, if the similarity probability is less than a predetermined value for a predetermined time (e.g., 0.5 sec) in which the encoder compresses the audio signal, the trigger voice determination module 330 may stop the compressing operation of the encoder 340. However, as reference numeral 510 illustrated in FIG. 5, if the similarity probability exceeds the predetermined value for a predetermined time (e.g., 0.5 sec) that the encoder 340 compresses the audio signal, the trigger voice determination module 330 may maintain the compression operation of the encoder 340.

Accordingly, unnecessary power consumption would be prevented because a useless compressing operation may not be performed if a trigger voice is not included in the audio signal.

In addition, the trigger voice determination module 330 may finally identify whether part of the input audio signal is a trigger voice, and identify whether the compressed audio signal would be recovered based on the determination result.

Specifically, if part of the input audio signal is identified as a trigger voice, the trigger voice determination module 330 may turn on the decoder 360 and recover the compressed audio signal. Especially, when a similarity probability is identified in real time, if the similarity possibility is less than a predetermined value but part of the audio signal lastly input is identified as a trigger voice, the trigger determination module 330 restarts the compression operation which has been stopped, compresses the instruction section in the input audio signal, stores the compressed section in the second buffer 350, and recover the audio signal in the compressed instruction section.

Especially, if it is identified that part of the input audio signal is a trigger voice, the trigger voice determination module 330 may turn on the electronic device 200 by controlling a power consumption unit (not illustrated) and output at least part of the audio signal (e.g., an instruction) input to the AP 240.

When the recovered audio signal is input, the AP 240 may activate the application corresponding to the audio signal and perform the function of an application by using the instruction excluding the audio signal corresponding to the trigger voice. For example, if the input audio signal is "Hi, Galaxy, what time is it?", the AP 240 may activate a clock application which corresponds to "what time is it?" in the input audio signal, so as to provide guide information regarding the current time.

However, if it is identified that part of the input audio signal is not the trigger voice, the trigger voice determination module 330 may turn off the decoder 360 and not perform a recovering operation. Accordingly, the compressed audio signal stored in the second buffer 350 may be deleted.

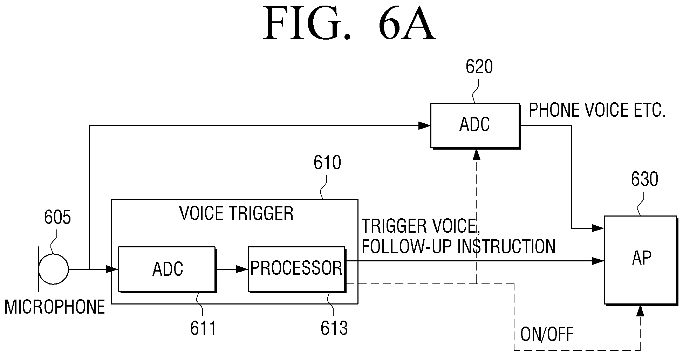

Meanwhile, according to an embodiment, the processor 230 which activates the electronic device 200 through the trigger voice in an inactivation status of the electronic device 200 may be implemented in a single chip. Especially, as illustrated in FIG. 6A, the chip 610 for recognizing the trigger voice may include an exclusive ADC 611 and a processor 613 for activating the electronic device 200 through the trigger voice. Here, the electronic device 200 may additionally include the ADC chip 620 for processing a phone voice and the like input through a microphone 605, and transmit the voice signal output from the chip 610 for recognizing the trigger voice and from the ADC chip 620 to the AP 630. As such, by implementing the chip 610 for recognizing the trigger voice, the electronic device 200 may turn off all chips excluding the chip 610 for recognizing the trigger voice when waiting for the trigger voice, and thus a low power driving may be performed.

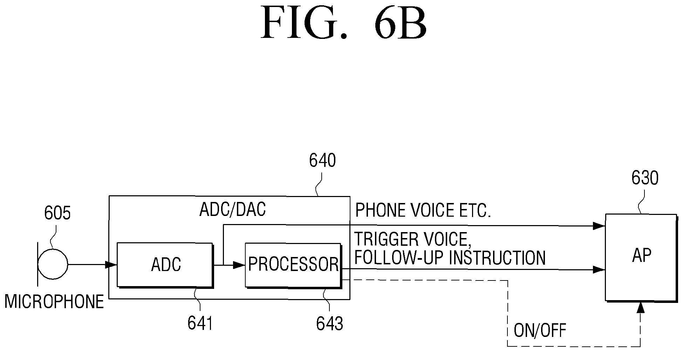

According to another embodiment, a processor 643 for recognizing the trigger voice may be included in the ADC chip 640 as illustrated in FIG. 6B. In this case, the processor 643 may process the audio signal input by using the ADC 641 included in the ADC chip 640. In this case, the ADC module needed for the configuration for recognizing the trigger voice could be replaced to the ADC module in the ADC chip 640, and thus a manufacturing cost may be reduced.

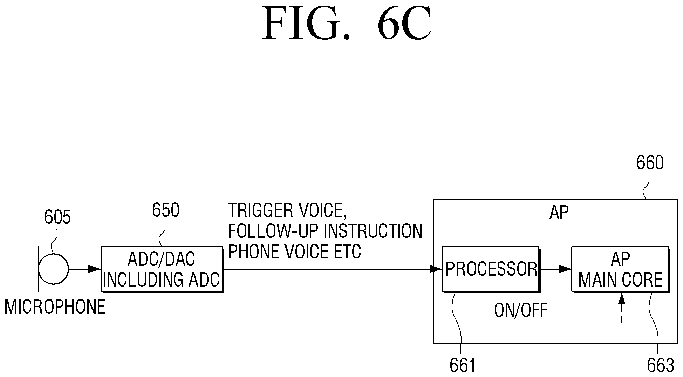

According to another embodiment, the processor 661 for recognizing the trigger voice may be included in the AP 660, as illustrated in FIG. 6C. In this case, the processor 661 may identify whether the trigger voice is input based on the audio signal processed through an external ADC chip 650, and transmit a control instruction to an AP main core 663 included in the AP 660. In this case, a key word and an instruction may be stored in the AP directly.

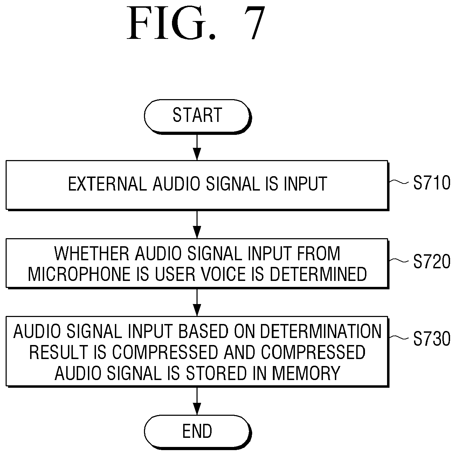

FIG. 7 is a block diagram briefly illustrating a controlling method of an electronic device according to an embodiment.

First, the electronic device 100 receives an external audio signal in S710. Here, the audio signal may include a user voice, and the user voice may include a trigger voice and an instruction.

In addition, the electronic device 100 may identify whether the audio signal input through a microphone is a user voice in S720.

In addition, the electronic device 100 may compress the audio signal input based on the determination result and store the compressed audio signal in a memory in S730. In detail, if the audio signal input from the microphone is a user voice, the electronic device 100 may compress the input audio signal and store the compressed audio signal in the memory, and if the input audio signal is not the user voice, the electronic device 100 may not compress and delete the input audio signal.

As described above, the size of the memory which will be included in the electronic device 100 may be reduced by compressing and storing the audio signal input based on the determination whether the audio signal is a user voice. Accordingly, the electronic device 100 may be driven with low power while maintaining the inactivation status.

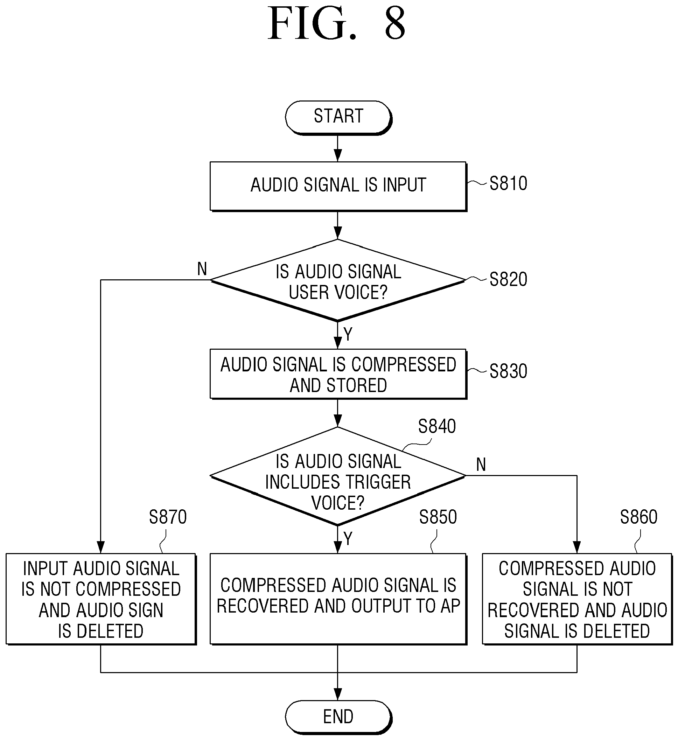

FIG. 8 is a block diagram illustrating a controlling method of the electronic device in detail according to an embodiment.

First, the electronic device 100 receives an audio signal in S810.

In addition, the electronic device 100 identifies whether the audio signal is a user voice in S820.

If it is identified that the audio signal is a user voice in S820-Y, the electronic device 100 compresses and stores the audio signal in S830.

In addition, the electronic device 100 identifies whether a trigger voice is included in the audio signal in S840.

If it is identified that the audio signal includes the trigger voice in S840-Y, the electronic device 100 recovers the compressed audio signal and outputs the recovered audio signal to the AP in S850. Here, the electronic device 100 may be activated by the trigger voice.

However, if it is identified that the audio signal does not include the trigger voice in S840-N, the electronic device 100 does not recover the compressed audio signal and deleted the compressed audio signal in S860.

In addition, if it is identified that the audio signal is not a user voice in S820-N, the electronic device 100 does not compress and delete the input audio signal in S870.

As illustrated in the above, the electronic device 100 may drive the chip for recognizing the trigger voice with low power, by identifying whether the audio signal is a user voice, and whether the audio signal includes the trigger voice, and by compressing/recovering the audio signal. In addition, the function corresponding to a follow-up instruction may be executed more rapidly by recognizing a follow-up instruction in addition to the trigger voice.

Although exemplary embodiments have been shown and described, it will be appreciated by those skilled in the art that changes may be made to the exemplary embodiments without departing from the principles and spirit of the present disclosure. The operations according to an exemplary embodiment may be realized by a single process. In this case, a program command for performing the operation implemented in various PCs may be recorded in a computer recordable medium. The computer-readable recording medium may include a program command, a data file, a data configuration and a combination thereof. The program commands are specially designed and configured for the embodiments or may be well known to a person skilled in the art. Examples of the computer-readable medium include magnetic recording media such as hard disks, floppy disks and magnetic tapes, optical recording media such as CD-ROMs and DVDs, magneto-optical recording media such as floptical disks, and hardware devices such as ROMs, RAMs and flash memories that are especially configured to store and execute program commands. Examples of the program commands include machine language codes created by a compiler, and high-level language codes that can be executed by a computer by using an interpreter. In the case in which part or all of a base station device or a relay is implemented as a computer program, the computer readable recording medium which stores the program may be included in the embodiments. Accordingly, the scope of the present disclosure is not construed as being limited to the described embodiments but is defined by the appended claims as well as equivalents thereto.

## Claims

1. An electronic device comprising:
a microphone configured to receive an external audio signal;
an Analog/Digital Converter (ADC) configured to process the audio signal to a digital signal;
a memory configured to store the audio signal; and
a processor configured to identify whether an audio signal input from the microphone is a user voice, compress the audio signal based on the determination result, and store the compressed audio signal in the memory,
wherein the ADC and the processor are implemented as a single chip.

2. The electronic device as claimed in claim 1, wherein the processor, in response to identifying that an audio signal input from the microphone is a user voice, compresses the audio signal and stores the compressed audio signal in the memory, and in response to identifying that an audio signal input from the microphone is not a user voice, does not compress the audio signal.

3. The electronic device as claimed in claim 1, wherein the processor identifies whether the compressed audio signal is recovered by identifying whether part of the audio signal is a trigger voice for activating the electronic device.

4. The electronic device as claimed in claim 3, comprising:
an application processor configured to control an application driven in the electronic device,
wherein the processor, in response to identifying that part of the audio signal is the trigger voice, recovers the compressed audio signal and outputs the recovered audio signal to the application processor, and in response to identifying that the audio signal is not the trigger voice, does not recover the compressed audio signal stored in the memory.

5. The electronic device as claimed in claim 4, wherein the processor, in response to identifying that part of the audio signal is the trigger voice, outputs a signal for activating the application processor to the application processor.

6. The electronic device as claimed in claim 4, wherein the application processor, in response to the recovered audio signal being input, activates an application corresponding to the audio signal and performs a function of an application by using an instruction excluding part of the audio signal corresponding to the trigger voice.

7. The electronic device as claimed in claim 3, wherein the processor identifies a probability of part of the audio signal corresponding to the trigger voice in real time while the audio signal is compressed, and in response to identifying that the probability identified in real time is less than a predetermined value, stops compression of the audio signal, and
wherein the processor, in response to a final probability that part of the audio signal corresponds to the trigger voice being equal to or greater than a predetermined value, compresses a section corresponding to a remaining instruction excluding the part of the audio signal and stores the compressed section in the memory.

8. A method for controlling an electronic device comprising:
receiving an external audio signal;
identifying whether an audio signal input from the microphone is a user voice; and
compressing the input audio signal based on the determination result and storing the compressed audio signal in a memory.

9. The method as claimed in claim 8, wherein the storing comprises, in response to identifying that an audio signal input from the microphone is a user voice, compressing the audio signal and storing the compressed audio signal in the memory, and in response to identifying that an audio signal input from the microphone is not a user voice, not compressing the audio signal.

10. The method as claimed in claim 8, further comprising:
identifying whether part of the audio signal is a trigger voice for activating the electronic device, and identifying whether the compressed audio signal is recovered.

11. The method as claimed in claim 10, comprising:
in response to identifying that the audio signal is not the trigger voice, not recovering the compressed audio signal stored in the memory, and in response to identifying that part of the audio signal is the trigger voice, recovering the compressed audio signal and outputting the recovered audio signal to the application processor.

12. The method as claimed in claim 11, comprising:
in response to identifying that part of the audio signal is the trigger voice, outputting a signal for activating the application processor to the application processor.

13. The method as claimed in claim 11, comprising:
in response to the recovered audio signal being input, activating an application corresponding to the audio signal by the application processor, and performing a function of an application by using an instruction excluding part of the audio signal corresponding to the trigger voice.

14. The method as claimed in claim 10, wherein the identifying comprises:
identifying a probability of part of the audio signal corresponding to the trigger voice in real time while the audio signal is compressed; and
stopping compression of the audio signal in response to identifying that the change identified in real time is less than a predetermined value,
wherein the method comprises:
in response to a final probability that part of the audio signal corresponds to the trigger voice being equal to or greater than a predetermined value, compressing a section corresponding to a remaining instruction excluding part of the audio signal and storing the compressed section in the memory.

15. A non-transitory computer readable storage medium configured to store one or more computer programs including instructions that, when executed by at least one processor, cause the at least one processor to control for a method for transmitting a control command of an electronic device, the method comprising:
receiving an external audio signal;
identifying whether an audio signal input from the microphone is a user voice; and
compressing the input audio signal based on the determination result and storing the compressed audio signal in a memory.
